(19) Europäisches Patentamt / European Patent Office / Office européen des brevets

(11) **EP 1 622 273 B1**

(12) **FASCICULE DE BREVET EUROPEEN**

(45) Date de publication et mention
de la délivrance du brevet:
**15.08.2007 Bulletin 2007/33**

(51) Int Cl.:
***H03M 1/18*** *(2006.01)*

(21) Numéro de dépôt: **05291408.2**

(22) Date de dépôt: **30.06.2005**

(54) **Dispositif de lecture amplifiée d'une information analogique avec commande de gain linéaire en dB, en particulier pour un capteur d'images**

Vorrichtung mit verstärktem Messwert einer analogen Information mit linearer Verstärkungsregelung in dB, insbesondere für einen Bildsensor

Apparatus with amplified reading of an analogue information with linear gain control in dB, especially for image pickup

(84) Etats contractants désignés:
**DE FR GB IT**

(30) Priorité: **29.07.2004 FR 0408357**

(43) Date de publication de la demande:
**01.02.2006 Bulletin 2006/05**

(73) Titulaire: **STMicroelectronics SA
92120 Montrouge (FR)**

(72) Inventeur: **Simony, Laurent
38100 Grenoble (FR)**

(74) Mandataire: **Casalonga, Axel
Bureau Casalonga & Josse
Bayerstrasse 71/73
80335 München (DE)**

(56) Documents cités:
**US-A1- 2002 105 449**

• **PATENT ABSTRACTS OF JAPAN vol. 010, no. 367 (E-462), 9 décembre 1986 (1986-12-09) & JP 61 163721 A (FUJI ELECTRIC CO LTD; others: 01), 24 juillet 1986 (1986-07-24)**
• **PATENT ABSTRACTS OF JAPAN vol. 1999, no. 08, 30 juin 1999 (1999-06-30) & JP 11 069242 A (KONICA CORP), 9 mars 1999 (1999-03-09)**

**Description**

L'invention concerne la lecture amplifiée d'une information analogique avec commande de gain linéaire en décibel (dB). Elle s'applique avantageusement mais non limitativement au traitement des signaux délivrés par une matrice de pixels d'un capteur d'images.

Les informations analogiques en provenance de la matrice de pixels sont lues par une chaîne de lecture ou de traitement, comportant notamment des moyens d'amplification à gain ajustable.

Le gain doit être défini avec précision pour tenir compte des différentes couleurs, de façon à effectuer un équilibrage des couleurs avec la précision requise ainsi qu'une restitution précise de celles-ci.

US 2002105449 décrit un système pour augmenter la plage dynamique d'un convertisseur analogique numérique sigma delta multi-bits sans dégrader l'efficacité de la mise en forme du bruit ou rendre le convertisseur instable.

L'invention vise à obtenir une commande de gain linéaire en dB, de façon simple à réaliser.

L'invention propose donc un dispositif de lecture amplifiée d'une information analogique avec commande de gain linéaire en décibel, comprenant :

- un moyen d'amplification à gain ajustable recevant ladite information analogique et dont les $2^j$ valeurs successives du gain, respectivement ajustables par $2^j$ valeurs successives d'un premier mot de commande de j bits, suivent une progression géométrique de raison a,
- un moyen de conversion analogique numérique connecté à la sortie du moyen d'amplification, possédant une pleine échelle d'entrée ajustable dont les $2^k$ différentes valeurs, respectivement ajustables, pour chaque valeur du gain, à partir de $2^k$ valeurs successives d'un deuxième mot de commande de k bits, suivent une progression géométrique de raison $\alpha^{1/2^k}$ , ledit moyen de conversion délivrant un

code numérique correspondant à ladite information analogique amplifiée par un gain global dont la valeur dépend de la valeur du gain de l'amplificateur et de celle de ladite pleine échelle, et

- des moyens de commande aptes à délivrer les premier et deuxième mots de commande.

L'amplificateur permet ainsi la réalisation de gains « grossiers », la commande du gain grossier étant réalisée sous forme d'un mot numérique de j bits.

Par ailleurs, l'ajustage de la pleine échelle d'entrée du convertisseur analogique/numérique permet de faire varier le gain de ce convertisseur analogique/numérique, de façon à obtenir un réglage fin du gain de la chaîne de lecture.

Lorsque la commande p (gain grossier) est incrémentée d'une unité, le gain, exprimé en dB, augmente de $20.\log_{10}(a)$. L'incrément en dB étant une valeur fixe, on parle alors de gain linéaire en dB.

De la même façon, l'ajustage de la pleine échelle d'entrée est fait de manière à avoir aussi une progression linéaire en dB pour le réglage fin du gain.

L'invention permet ainsi d'obtenir un réglage fin du gain global de la chaîne de lecture en n'utilisant qu'un seul amplificateur. Ceci est particulièrement avantageux du point de vue rapport signal à bruit.

Par ailleurs, la réalisation d'une telle loi de commande linéaire en dB, en n'utilisant un seul amplificateur et un convertisseur analogique numérique, se distingue d'une réalisation d'une telle loi de commande par un autre moyen, par exemple des amplificateurs linéaires en dB connus en soi, mais qui se révèlent être moins bien appropriés à l'application d'un capteur d'images.

Le dispositif comprend avantageusement des moyens de commande délivrant un mot global de commande de j+k bits, dont les j bits de poids forts forment ledit premier mot de commande et dont les k bits de poids faibles forment le deuxième mot de commande.

En d'autres termes, l'utilisateur règle le gain total de chaîne par un mot numérique de j+k bits, où les j bits de poids forts déterminent le gain grossier, où les k bits de poids faibles déterminent le gain fin, et toute incrémentation de ce mot de j+k bits a pour conséquence un accroissement du gain total de chaîne (exprimé en dB) d'une valeur fixe.

Selon un mode de réalisation de l'invention, le dispositif comprend des moyens d'élaboration aptes à élaborer les $2^k$ valeurs de la pleine échelle d'entrée, en réponse au deuxième mot de commande de k bits, ces moyens d'élaboration comportant un convertisseur analogique numérique du type exponentiel possédant un multiplexeur commandable par ledit deuxième mot de commande, ainsi qu'un diviseur potentiométrique connecté entre deux bornes recevant respectivement des valeurs maximale et minimale de pleine échelle, et dont les résistances suivent une progression géométrique de raison $\alpha^{1/2^k}$.

Par ailleurs, le dispositif comprend avantageusement des moyens de calibrage aptes à effectuer pour chaque valeur p de gain, un préréglage de la valeur maximale de pleine échelle Emax,p et de la valeur minimale de pleine échelle Emin,p, de sorte que Emax,p / Emin,p soit égal à $\alpha^{1/2^k}$.

L'invention propose également un capteur d'images comportant une chaîne de lecture incorporant un dispositif de lecture amplifié tel que défini ci-avant.

D'autres avantages et caractéristiques de l'invention apparaîtront à l'examen de la description détaillée de modes de réalisation, nullement limitatifs, et des dessins annexés, sur lesquels :

- la figure 1 représente schématiquement un capteur d'image selon l'invention, dont la chaîne de lecture incorpore un dispositif selon l'invention ;
- la figure 2 illustre plus en détail, mais toujours de façon schématique, une partie du dispositif de la figure 1 ;
- la figure 3 est un tableau illustrant l'évolution des gains obtenus par un dispositif selon l'invention ; et
- les figures 4 et 5 illustrent des moyens permettant un calibrage du dispositif.

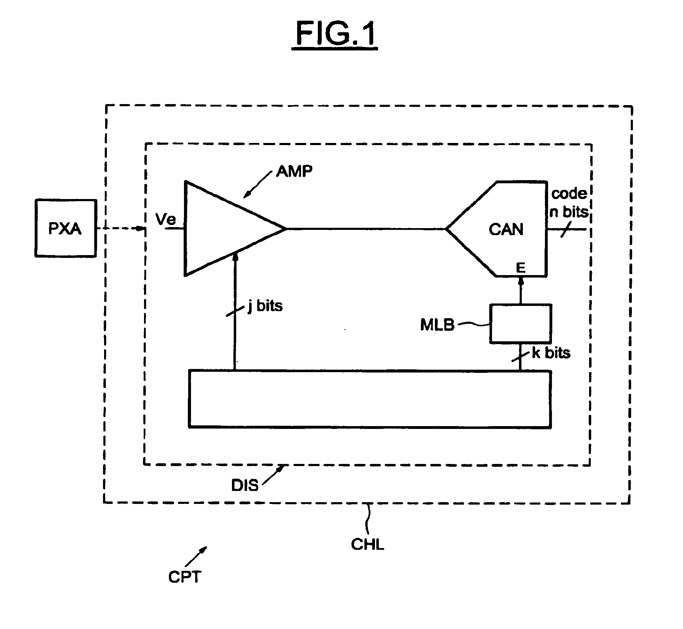

Sur la figure 1, la référence CPT désigne un capteur d'image comportant notamment une matrice de pixels PXA ainsi qu'une chaîne de lecture CHL incorporant un dispositif d'amplification DIS selon l'invention.

Le dispositif DIS comporte un amplificateur AMP à gain ajustable, suivi d'un convertisseur analogique-numérique CAN à n bits de résolution.

Des moyens de commande MCM délivrent un mot de j+k bits, dans lequel les j bits de poids forts permettent de commander le gain de l'amplificateur AMP. De façon classique, les valeurs des j bits du mot de commande permettent de rendre passants ou bloqués des transistors permettant de faire varier la valeur de circuit résistif et/ou capacitif agissant sur la valeur du gain de l'amplificateur AMP.

Le gain de l'amplificateur AMP s'exprime par la relation

$$A = A_0 \cdot a^p$$

où :

- $A_0$ est une constante (valeur minimale du gain) ;
- a est une constante supérieure à 1 ;
- p est la valeur de la commande de gain (commande sur j bits variant de 0 à $2^j - 1$

En ce qui concerne le convertisseur analogique-numérique, le résultat de conversion d'une tension d'entrée V s'exprime par

$$Code = V \cdot 2^n / E_i$$

où $E_i$ est la pleine échelle d'entrée du convertisseur.

L'indice i correspond à une commande sur k bits, donc varie de 0 à $2^k - 1$

La valeur de la pleine échelle $E_i$ est définie par des moyens d'élaboration MLB à partir des k bits de poids faibles du mot de commande délivré par les moyens de commande MCM.

Le gain total de chaîne vaut donc : *Gain* = $A_0 \cdot \alpha^p \cdot 2^n / E_i$ (exprimé en quantum par volt).

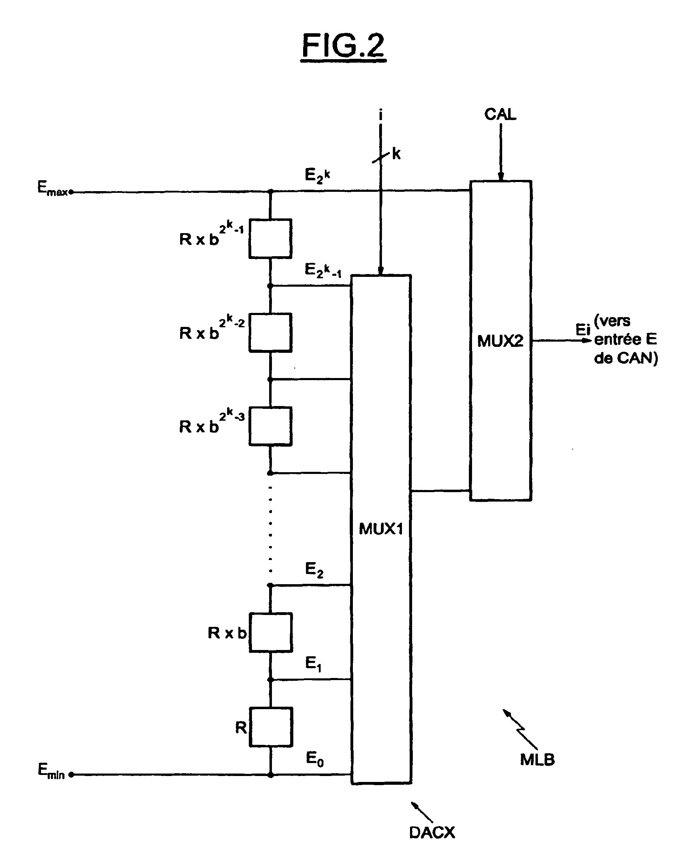

Les $2^k$ valeurs distinctes de la pleine échelle du convertisseur CAN, notées $E_i$, où i varie de 0 à $2^{k-1}$, sont obtenues en utilisant un convertisseur numérique-analogique exponentiel DACX incorporé dans les moyens d'élaboration MLB (figure 2).

Ce convertisseur numérique-analogique exponentiel comporte un diviseur potentiométrique dont les résistances suivent une progression géométrique de rapport b. Un multiplexeur MUX1 permet de sélectionner la valeur correspondante de la pleine échelle.

L'ajustage de la pleine échelle permet de faire varier le gain du convertisseur analogique-numérique CAN pour obtenir un réglage fin du gain de la chaîne de lecture CHL. En pratique, la plage dans laquelle il est possible de régler la pleine échelle sans compromettre la performance du convertisseur est limitée. En effet, cette plage [$E_{max}$, $E_{min}$] doit être telle que $E_{max}/E_{min}$ est inférieur à 2. Le rapport acceptable des pleines échelles ($E_{max}/E_{min}$) fixe une borne maximale au paramètre a (raison de la progression des gains de l'amplificateur).

Le rapport b de la progression géométrique des résistances du diviseur potentiométrique du convertisseur numérique-analogique exponentiel est l'incrément unitaire de gain de chaîne, c'est-à-dire celui en incrémentant le mot de j+k bits. Il peut être calculé de la façon suivante : sachant qu'au bout de $2^k$ codes, on incrémente le gain grossier, le gain total de chaîne est multiplié par a. On a donc :

$$b^{2^k} = a$$

soit : $b = a^{1/2^k}$

Or, le code de sortie est

$$Code = V \cdot 2^n / E_i$$

où i est la valeur du mot de k bits. Quand ce mot est augmenté, le code doit être multiplié par b, donc $E_i$ doit être divisé par b, donc :

$$E_{i+1} = E_i/b$$

La valeur maximale de E est $E_{max} = E_0$ (correspondant au gain fin minimal).

La valeur minimale de E est $E_{min} = E_{2k-1}$ (correspondant au gain minimal).

Le diviseur potentiométrique permet donc d'obtenir le rapport b entre $E_{i+1}$ et $E_i$.

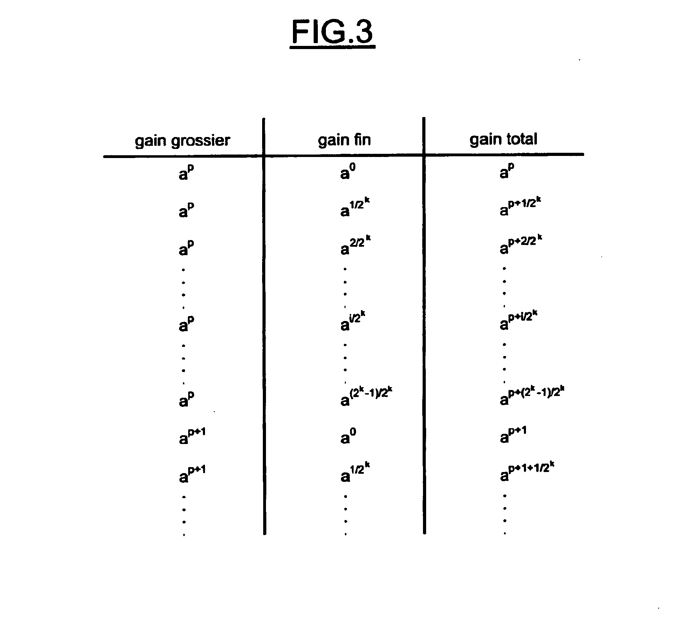

Le gain grossier, le gain fin et le gain total de la chaîne de lecture suivent ainsi une progression partiellement illustrée dans le tableau de la figure 3.

Lorsque la commande p est incrémentée, le gain - exprimé en dB - augmente de $20.\log_{10}(a)$. L'incrément en dB étant une valeur fixe, on parle de « gain linéaire en dB ».

De la même façon, l'ajustage de la pleine échelle est fait de manière à avoir aussi une progression linéaire en dB pour le réglage fin du gain.

Quand la commande de gain fin atteint sa valeur maximale (c'est-à-dire quand i atteint $2^k$-1), la position suivante de réglage de gain de la chaîne est obtenue en remettant i=0 et en incrémentant la valeur de p (commande de gain grossier). L'accroissement de gain réalisé dans ce cas doit être égal à un pas d'accroissement du réglage fin.

De cette manière, l'utilisateur règle le gain total de chaîne par un mot binaire de (j+k) bits, où les j bits de poids forts déterminent le gain grossier, les k bits de poids faibles déterminent le gain fin, et toute incrémentation de ce code de (j+k) bits a pour conséquence un accroissement du gain total de chaîne (exprimé en dB) d'une valeur fixe.

En pratique, l'accroissement élémentaire du gain de chaîne (facteur b) est faible par rapport à la précision qu'il est possible d'obtenir pour le réglage du gain grossier (précision sur le facteur a).

Par conséquent, l'accroissement du gain de chaîne, quand p est incrémenté, ne peut pas être garanti de par la précision de fabrication du circuit intégré.

Il faut donc régler précisément les valeurs de $E_{max}$ et de $E_{min}$ pour chaque valeur de p. Ainsi $E_{max.p}$ et $E_{min,p}$ doivent être réglables.

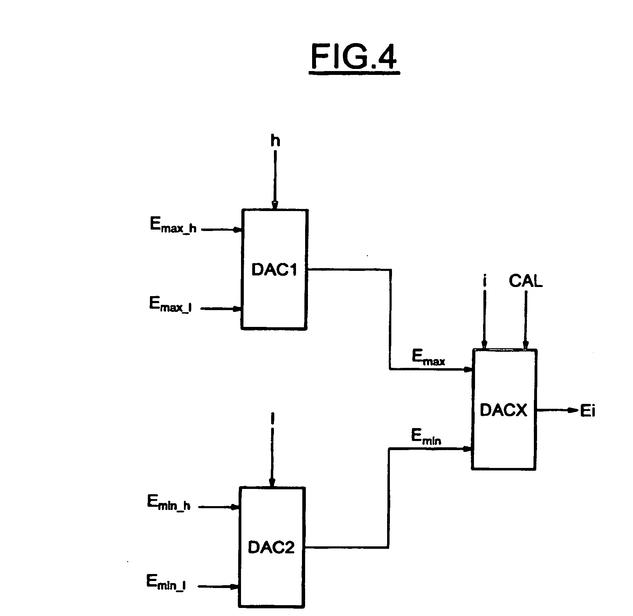

Ces réglages seront réalisés au moyen de deux convertisseurs numériques-analogiques supplémentaires DAC1, DAC2 (figure 4), et doivent être mémorisés lors d'une procédure de calibrage, préalable à l'utilisation du dispositif.

Il faut théoriquement régler $E_{min.p}$ par rapport à $E_{max.p+1}$ de manière à ce que $E_{min.p}/E_{max.p+1}$ = b.

Cette opération, qui nécessite d'amplifier $E_{max.p+1}$ par b, nécessite donc une forte précision (b pouvant être de l'ordre de +1% par exemple). Cependant, il est possible de simplifier le problème, comme expliqué ci-après.

En pratique, le convertisseur numérique-analogique délivrant les valeurs de E, dispose de la précision nécessaire. Il est alors facile de prévoir une sortie supplémentaire, notée $E_{2^k}$, qui suit immédiatement $E_{2^k-1}$ dans la progression géométrique. Cette position (accessible en utilisant la commande « CAL ») est censée fournir un gain du convertisseur analogique-numérique CAN valant $b^{2k}$ = a. Le gain de chaîne total vaut alors :

$$a^p \cdot a = a^{p+1}$$

Comme le même gain peut être obtenu par un mot de commande différent (p+1 et i=0), la procédure opèrera en recherchant une égalité, ce qui est plus simple à réaliser qu'une amplification par le facteur b.

La mise en oeuvre de la procédure de calibrage nécessite des moyens de réglage supplémentaires (figures 4 t 5).

Ainsi, outre les deux convertisseurs numériques-analogiques DAC1 et DAC2 pour le réglage de max et $E_{min}$ à chaque étape de calibrage, il est prévu des moyens de mémorisation MM pour mémoriser les réglages de ces deux convertisseurs DAC1 et DAC2 correspondant à chaque valeur de b (soit 2x2$^j$ valeurs associées aux 2$^j$ valeurs de b).

Il est également nécessaire de prévoir une commande supplémentaire (CAL), permettant d'accéder à une sortie supplémentaire du convertisseur numérique-analogique. Cette commande supplémentaire n'est accessible qu'en mode de calibrage.

Le gain n'est pas une grandeur directement accessible, il faut donc injecter un signal calibré de manière à opérer sur des tensions.

De plus, il faut tenir compte du fait que l'amplificateur possède un décalage (offset) : c'est la valeur de sa sortie lorsque le signal injecté est nul.

Le réglage consistant à rechercher une égalité entre deux positions de gains, il faut donc amplifier un signal calibré dans les deux positions convenues, et parfaire les réglages de $E_{max}$ et $E_{min}$ de manière à obtenir des codes de sortie identiques en sortie du convertisseur analogique-numérique CAN.

Ce signal calibré doit être choisi de manière à produire une tension suffisamment grande (pour ne pas être limité par la résolution du convertisseur analogique-numérique CAN dans le cas où $E = E_{min}$.

Ce signal de calibrage dépend du gain de chaîne (de la commande p), et doit être tel que la sortie de l'amplificateur soit suffisamment grande (pour ne pas être limité par des problèmes de précision).

Il est souhaitable de travailler à amplitude de sortie constante en sortie de l'amplificateur. Dans ce cas, le signal à injecter doit suivre une loi de la forme $1/c^p$, p variant de 1 à 2$^j$.

Il existe diverses manières de procéder afin de calibrer la chaîne.

La méthode proposée permet de faire en sorte que l'accroissement de gain soit constant sur toute la gamme de commande de (j+k) bits.

Quand on change la commande de l'amplificateur (code sur j bits), le gain de ce dernier est en général contrôlé par un rapport de résistances ou de capacités : la précision absolue de ce contrôlé n'est pas nécessairement suffisante par rapport au réglage fin.

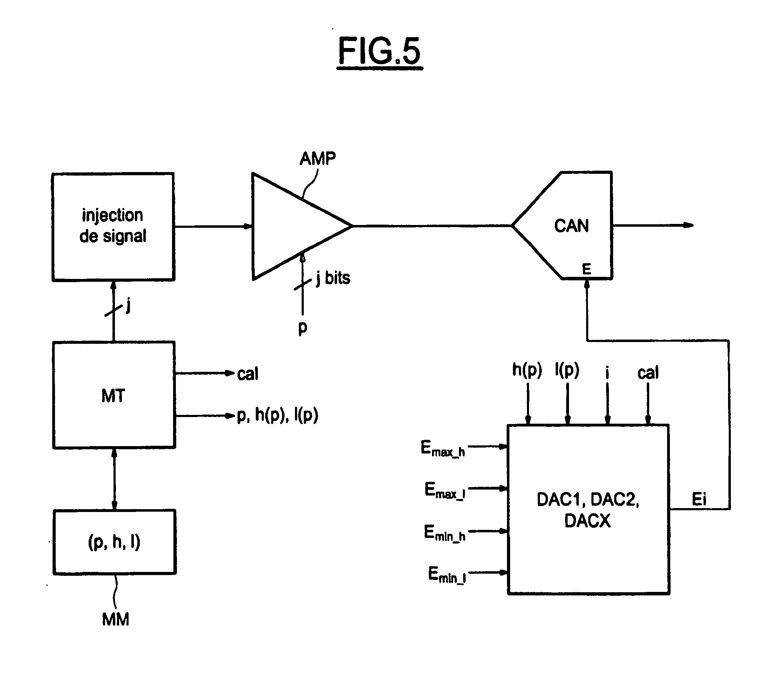

La méthode proposée ici pour calibrer la chaîne est la méthode dite de la droite de régression bien connue en soi par l'homme du métier. L'algorithme de mise en oeuvre va maintenant être décrit ci-dessous et est implanté dans des moyens de traitement MT.(figure 5) :

> 1. Mesurer les gains obtenus en ne modifiant que la commande p de l'amplificateur (2$^j$ positions). Pendant toute cette opération,
>
> > a) la valeur de E est maintenue à une valeur $E_{max}$ typique pour avoir le gain fin minimum ;
> > b) le signal injecté garde une valeur constante minimale de manière à ne jamais saturer le convertisseur analogique-numérique CAN, quel que soit le gain de l'amplificateur ;
> > c) pour chaque valeur de p, il faut également extraire l'offset en injectant un signal nul.
>
> 2. Calculer les gains et les convertir en dB.
> 3. Sachant que la courbe gain_dB = f(p) est censée être une droite, calculer la droite de régression.
> 4. Pour chaque valeur de p, et en partant de la val eur la plus grande (=2$^j$-1),
>
> > a. positionner le gain de l'amplificateur à $A_0.a^p$
> > b. injecter un signal de la forme $1/c^p$. (Partir de la valeur de p la plus grande permet de retomber dans le cas du signal injecté minimal, c'est-à-dire le cas utilisé précédemment (1.b).
> >
> > > i. Régler d'abord $E_{min\_p}$ de manière à ce que le gain total corresponde à la droite de régression. $E_{min\_p}$ est obtenu en utilisant i=0.
> > > ii. Régler ensuite $E_{max\_p}$ (utiliser pour cela la commande CAL) de manière à ce que le nouveau gain obtenu tombe sur la droite de régression (valeur idéale théorique = gain i obtenu avec $E_{min\_p}$, divisé par b).
> > > iii. Tout en gardant le même signal injecté $1/c^P$, régler le gain de l'amplificateur à $A_0.a^{p-1}$, et régler $E_{min\_p-1}$ de manière à retrouver le même gain de chaîne qu'en ii). Ceci est nécessaire car les deux réglages « ii » et « iii » doivent donner le même gain.
> > > iv. Décrémenter p et injecter maintenant un signal $1/c^{p+1}$, sans changer le réglage de gain [ce gain est donc celui calibré en iii]. Relever le nouveau signal utile obtenu.
> > > v. Boucler en ii, jusqu'à atteindre p=0.

En sortant de cette boucle, le gain est calibré.

L'invention permet ainsi de réaliser un gain total de chaîne avec un seul étage analogique, de manière, d'une part, à favoriser le rapport signal à bruit, et, d'autre part, à limiter la consommation. Le gain total de chaîne est réglable avec précision, par exemple de l'ordre de 1 à 2% pour une reconstitution d'une image couleur.

Le gain de l'amplificateur est réglable par grossier et la pleine échelle du convertisseur analogique-numérique est modulée, de manière à obtenir un réglage fin linéaire en dB.

Cette structure est associée à une méthode de calibrage de gain, permettant d'assurer la monotonicité du contrôle de gain entre le réglage grossier (MSB) et le réglage fin (LSB).

**Revendications**

1. Dispositif de lecture amplifiée d'une information analogique avec commande de gain linéaire en décibel, **caractérisé par le fait qu'**il comprend

   - un moyen d'amplification à gain ajustable (AMP) recevant ladite information analogique et dont les $2^j$ valeurs successives du gain, respectivement ajustables par $2^j$ valeurs successives d'un premier mot de commande de j bits, suivent une progression géométrique de raison a,
   - un moyen de conversion analogique numérique (CAN) connecté à la sortie du moyen d'amplification, possédant une pleine échelle d'entrée ajustable dont les $2^k$ différentes valeurs, respectivement ajustables, pour chaque valeur du gain, à partir de $2^k$ valeurs successives d'un deuxième mot de commande de k bits, suivent une progression géométrique de raison $\alpha^{1/2k}$, ledit moyen de conversion délivrant un code numérique correspondant à ladite information analogique amplifiée par un gain global dont la valeur dépend de la valeur du gain de l'amplificateur et de celle de ladite pleine échelle, et
   - des moyens de commande (MCM) aptes à délivrer les premier et deuxième mots de commande.

2. Dispositif selon la revendication 1, **caractérisé par le fait qu'**il comprend des moyens de commande (MCM) délivrant un mot global de commande de j+k bits, dont les j bits de poids forts forment ledit premier mot de commande et dont les k bits de poids faibles forment ledit deuxième mot de commande.

3. Dispositif selon l'une des revendications précédentes, **caractérisé par le fait qu'**il comprend des moyens d'élaboration (MLB) aptes à élaborer les $2^k$ valeurs de la pleine échelle d'entrée, en réponse au deuxième mot de commande de k bits, ces moyens d'élaboration comportant un convertisseur analogique numérique du type exponentiel (DACX) possédant un multiplexeur commandable par ledit deuxième mot de commande, ainsi qu'un diviseur potentiométrique connecté entre deux bornes recevant respectivement des valeurs maximale et minimale de pleine échelle, et dont les résistances suivent une progression géométrique de raison $\alpha^{1/2k}$.

4. Dispositif selon la revendication 3, **caractérisé par le fait qu'**il comprend des moyens de calibrage (DAC1, DAC2, MT) aptes à effectuer pour chaque valeur p de gain, un préréglage de la valeur maximale de pleine échelle Emax, p et de la valeur minimale de pleine échelle Emin,p, de sorte que Emax,p / Emin,p soit égal à $a^{1/2k}$.

5. Dispositif selon la revendication 4, **caractérisé par le fait que** les moyens de calibrage sont aptes à rechercher une égalité entre deux positions de gains respectivement obtenues avec deux mots de commande différents.

6. Dispositif selon la revendication 5, **caractérisé par le fait que**, les gains étant réglés sur lesdites deux positions, les moyens de calibrage sont aptes à injecter un signal de calibrage choisi dans ces deux positions, et à régler la valeur maximale de pleine échelle et la valeur minimale de pleine échelle de façon à obtenir des codes numériques identiques.

7. Dispositif selon la revendication 6, **caractérisé par le fait que** le signal de calibrage injecté suit une loi de la forme $1/c^p$, p variant de 1 à $2^j$.

8. Capteur d'images, **caractérisé par le fait qu'**il comporte une chaîne de lecture incorporant un dispositif selon l'une des revendications 1 à 7.

**Claims**

1. Amplified analogue information reading device with linear decibel mode gain control, **characterized in that** it comprises:

   - an adjustable gain amplification means (AMP) receiving said analogue information and of which the $2^j$ successive gain values, respectively adjustable by $2^j$ successive values of a first control word of j bits, follow a geometric progression of ratio a,

- an analogue/digital conversion means (CAN) connected to the output of the amplification means, having an adjustable input full-scale of which the $2^k$ different values, respectively adjustable, for each gain value, from $2^k$ successive values of a second control word of k bits, follow a geometric progression of ratio a $^{1/2k}$ , said conversion means delivering a digital code corresponding to said analogue information amplified by an overall gain, the value of which depends on the gain value of the amplifier and on that of said full-scale, and

- control means (MCM) designed to deliver the first and second control words.

2. Device according to Claim 1, **characterized in that** it comprises control means (MCM) delivering a global control word of j+k bits, of which the j high order bits form said first control word and of which the k low order bits form said second control word.

3. Device according to one of the preceding claims, **characterized in that** it comprises generation means (MLB) designed to generate the $2^k$ input full-scale values, in response to the second control word of k bits, these generation means including an exponential type analogue/digital converter (DACX) having a multiplexer controllable by said second control word, and a potentiometric divider connected between two terminals respectively receiving full-scale maximum and minimum values, and the resistances of which follow a geometric progression of ratio a $^{1/2k}$.

4. Device according to Claim 3, **characterized in that** it comprises calibration means (DAC1, DAC2, MT) designed, for each gain value p, to perform a preliminary adjustment of the full-scale maximum value Emax,p and of the full-scale minimum value Emin,p, such that Emax,p / Emin,p is equal to a $^{\frac{1}{2}k}$.

5. Device according to Claim 4, **characterized in that** the calibration means are designed to search for a match between two gain positions respectively obtained with two different control words.

6. Device according to Claim 5, **characterized in that**, the gains being adjusted to said two positions, the calibration means are designed to inject a calibration signal chosen from these two positions, and to adjust the full-scale maximum value and the full-scale minimum value so as to obtain identical digital codes.

7. Device according to Claim 6, **characterized in that** the calibration signal injected follows a law of the form $1/c^p$, p varying from 1 to $2^j$.

8. Image sensor, **characterized in that** it includes a reading subsystem incorporating a device according to any one of Claims 1 to 7.

**Patentansprüche**

1. Vorrichtung zum Lesen und Verstärken einer analogen Information mit einer linearen Verstärkungsfaktorsteuerung in Dezibel, **dadurch gekennzeichnet, daß** sie aufweist:

- eine Verstärkungseinrichtung (AMP) mit einstellbarem Verstärkungsfaktor, die die analoge Information empfängt und deren $2^j$ aufeinanderfolgende Werte des Verstärkungsfaktors, die jeweils durch $2^j$ aufeinanderfolgende Werte eines ersten Steuerworts mit j Bits einstellbar sind, einer geometrischen Reihe im Verhältnis a folgen,

- eine mit dem Ausgang der Verstärkungseinrichtung verbundene Analog-Digital-Wandlereinrichtung (CAN), die eine einstellbare volle Eingangsskala aufweist, deren $2^k$ unterschiedliche Werte, die jeweils ausgehend von $2^k$ aufeinanderfolgenden Werten eines zweiten Steuerworts mit k Bits für jeden Verstärkungswert einstellbar sind, einer geometrischen Reihe im Verhältnis a $^{1/2k}$ folgen, wobei die Wandlereinrichtung einen digitalen Code ausgibt, der der analogen Information, verstärkt mit einem globalen Verstärkungsfaktor, entspricht, dessen Wert von dem Verstärkungsfaktor des Verstärkers und demjenigen der vollen Skala abhängt, und

- Steuereinrichtungen (MCM), die in der Lage sind, das erste und zweite Steuerwort auszugeben.

2. Vorrichtung nach Anspruch 1, **dadurch gekennzeichnet, daß** sie Steuereinrichtungen (MCM) aufweist, die ein globales Steuerwort mit j+k Bits ausgeben, dessen j höherwertige Bits das erste Steuerwort bilden und dessen k niederwertige Bits das zweite Steuerwort bilden.

3. Vorrichtung nach einem der vorstehenden Ansprüche, **dadurch gekennzeichnet, daß** sie Ausarbeitungseinrichtungen (MLB) aufweist, die in der Lage sind, als Antwort auf das zweite Steuerwort mit k Bits die $2^k$ Werte der vollen Eingangsskala auszuarbeiten, wobei diese Ausarbeitungseinrichtungen einen Analog-Digital-Wandler des exponentiellen Typs (DACX) aufweisen, der einen von dem zweiten Steuerwort steuerbaren Multiplexer aufweist, sowie einen potentiometrischen Teiler aufweisen, der zwischen zwei Anschlüssen angeordnet ist, die jeweils den maximalen und den minimalen Wert der vollen Skala empfangen und dessen Widerstände einer geometrischen Reihe des Verhältnisses $a^{\frac{1}{2}k}$ folgen.

4. Vorrichtung nach Anspruch 3, **dadurch gekennzeichnet, daß** sie Kalibrierungseinrichtungen (DAC1, DAC2, MT) aufweist, die in der Lage sind, für jeden Verstärkungsfaktorwert p eine Vorabregelung des maximalen Werts der vollen Skala Emax,p und des minimalen Werts der vollen Skala Emin,p durchzuführen, so daß Emax,p/Emin,p gleich $a^{\frac{1}{2}k}$ ist.

5. Vorrichtung nach Anspruch 4, **dadurch gekennzeichnet, daß** die Kalibrierungseinrichtungen in der Lage sind, eine Gleichheit zwischen zwei Verstärkungsfaktorpositionen, die jeweils mit zwei unterschiedlichen Steuerwörtern gewonnen wurden, zu suchen.

6. Vorrichtung nach Anspruch 5, **dadurch gekennzeichnet, daß**, nachdem die Verstärkungsfaktoren auf diese zwei Positionen geregelt sind, die Kalibrierungseinrichtungen in der Lage sind, ein gewähltes Kalibrierungssignal in diese zwei Positionen hineinzubringen und den maximalen Wert der vollen Skala und den minimalen Wert der vollen Skala zu regeln, um identische digitale Codes zu erzielen.

7. Vorrichtung nach Anspruch 6, **dadurch gekennzeichnet, daß** das hineingebrachte Kalibrierungssignal einem Gesetz der Form $1/c^p$ folgt, wobei p zwischen 1 und $2^j$ variiert.

8. Bildsensor, **dadurch gekennzeichnet, daß** er eine Lesekette aufweist, die eine Vorrichtung nach einem der Ansprüche 1 bis 7 aufweist.

# FIG.1

# FIG.2

# FIG.3

| gain grossier | gain fin | gain total |
|:---:|:---:|:---:|
| $a^p$ | $a^0$ | $a^p$ |
| $a^p$ | $a^{1/2^k}$ | $a^{p+1/2^k}$ |
| $a^p$ | $a^{2/2^k}$ | $a^{p+2/2^k}$ |
| . | . | . |
| . | . | . |
| . | . | . |
| $a^p$ | $a^{i/2^k}$ | $a^{p+i/2^k}$ |
| . | . | . |
| . | . | . |
| . | . | . |
| $a^p$ | $a^{(2^k-1)/2^k}$ | $a^{p+(2^k-1)/2^k}$ |
| $a^{p+1}$ | $a^0$ | $a^{p+1}$ |
| $a^{p+1}$ | $a^{1/2^k}$ | $a^{p+1+1/2^k}$ |
| . | . | . |
| . | . | . |
| . | . | . |

# FIG.4

# FIG.5

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- US 2002105449 A